Europäisches Patentamt

European Patent Office

Office européen des brevets

(19)

(11) Veröffentlichungsnummer: **0 018 432**

**B1**

(12) EUROPÄISCHE PATENTSCHRIFT

(45) Veröffentlichungstag der Patentschrift: 24.02.82

(21) Anmeldenummer: 79102206.4

(22) Anmeldetag: 02.07.79

(51) Int. Cl.³: **C 23 C 11/08,**
**C 23 C 17/00, B 32 B 15/00**

(54) Mit einer verschleiss- und korrosionsfesten Wolframkarbid-Schutzschicht versehener Metallteil.

(30) Priorität: 04.05.79 CH 4189/79

(43) Veröffentlichungstag der Anmeldung:
12.11.80 Patentblatt 80/23

(45) Bekanntmachung des Hinweises auf die Patenterteilung:
24.02.82 Patentblatt 82/8

(84) Benannte Vertragsstaaten:
DE FR GB SE

(56) Entgegenhaltungen:
DE - A - 2 018 662
DE - A - 2 149 914
FR - A - 1 207 139
FR - A - 2 302 350
FR - A - 2 331 390
GB - A - 2 000 812
US - A - 3 564 565

TECHNISCHE RUNDSCHAU SULZER
FORSCHUNGSHEFT, 1978,
K. K. YEE: "WOLFRAM-KARBID-Verschleiss-
schutzschicht durch chemische
Gasphasenabscheidung", Seiten 105—107

(73) Patentinhaber: GEBRÜDER SULZER
AKTIENGESELLSCHAFT
Zürcherstrasse 9
CH-8401 Winterthur (CH)

(72) Erfinder: Yee, Kim Shee, Dr.
Wybüelstrasse 4
CH-8702 Zollikon (CH)
Erfinder: Straub, Werner
Heidenbühl
CH-8352 Räterschen (CH)

(74) Vertreter: Sparing, Nikolaus, Dipl.-Ing.
Rethelstrasse 123
D-4000 Düsseldorf 1 (DE)

# 0 018 432

Mit einer verschleiss- und korrosionsfesten Wolframkarbid-Schutzschicht versehener Metallteil

Die Erfindung betrifft einen Metallteil gemäß Oberbegriff von Anspruch 1. Metallteile, bei denen die Erfindung bevorzugt verwendet wird, sind vor allem Kleinteile, beispielsweise Uhrenbestandteile, insbesondere Uhrengehäuse, Uhrenarmbänder und Schmuck.

Es ist bekannt (CH—PS 600 407), als verschleiss-, insbesondere kratzfeste und korrosionsbeständige Ueberzüge auf Uhrengehäusen aus Stahl Schutzschichten aus Aluminiumoxiden, Karbiden, Nitriden, Boriden oder Siliziden der Metalle der III. und VI. Gruppe des periodischen Systems abzuscheiden. Als bevorzugter Prozess für die Abscheidung dient die chemische Abscheidung aus der Gasphase (CVD-Verfahren). Zwischen den Schutzschichten und dem Stahlteil ist dabei eine Zwischenschicht vorgesehen; diese besteht vorzugsweise aus Silizium oder Aluminium.

Aud Stahlteilen mit Hilfe einer chemischen Abscheidung aus der Gasphase als Verschleiss-Schutzschicht Wolframkarbid abzuscheiden und dabei zuvor eine Adhäsions-Zwischenschicht aus Nickel, Kobalt oder einer Legierung niederzuschlagen, ist aus der GB—PS 1 540 718 bekannt.

In der DE—OS 20 18 662 werden Verbundwerkstoffe für Schneidwerkzeuge beschrieben, bei denen auf einem zähen Substrat, beispielsweise aus Stahl, zunächst eine Zwischenschicht, dann eine verschleissfeste Deckschicht aus einem metallischen oder nichtmetallischen Hartstoff, beispielsweise einem Karbid, Borid oder Nitrid der Uebergangsmetalle, aufgebracht wird. Die Zwischenschicht soll dabei eine Härte zwischen derjenigen des Substrats und derjenigen der Deckschicht haben; ebenso soll ihr thermischer Ausdehnungskoeffizient zwischen demjenigen des Substrats und demjenigen der Deckschicht liegen.

Schließlich ist bereits vorgeschlagen worden, ebenfalls unter Verwendung einer Adhäsions-Zwischenschicht aus Nickel, deren Dicke bis zu 2,5 $\mu$m beträgt, neben Kleinteilen aus Stahl auch solche aus Bunt- und/oder Leichtmetallen, insbesondere aus Kupfer oder Aluminium und deren Legierungen, durch eine nach dem CVD-Verfahren hergestellte Verschleiss-Schutzschicht aus Wolframkarbid zu schützen (Techn. Rundschau Sulzer, Forschungsheft 1978, Seite 105 ff.).

In der Praxis hat sich nun gezeigt, dass bei Metallteilen bzw. Substraten, deren Material — wie die Cu- und Al-Basislegierungen verglichen mit der Wolframkarbid-Schicht relativ geringe Härten (gemessen beispielsweise nach Vickers in HV) und relativ grosse thermische Ausdehnungskoeffizienten $\alpha$ (gemessen als Längenänderung pro Grad) hat, die bisherigen Schutzschicht-Kombinationen zu ungenügenden Verschleissfestigkeiten, insbesondere Kraftfestigkeiten, führen; denn zum einen "bricht" die harte Wolframkarbid-Schicht — bei der dafür üblicherweise verwendeten Schichtdicke bis zu etwa 30 $\mu$m — schon bei relativ geringen Belastungen in den weichen Metallteil "ein" und zum anderen ist die Haftung der Wolframkarbid-Schicht auf dem Metallteil trotz der Adhäsions-Zwischenschicht ungenügend.

Der Grund hierfür liegt — ähnlich wie bei den erwähnten bekannten Verbundwerkstoffen — in den großen Unterschieden in der Härte und in der thermischen Ausdehnung zwischen dem Metallteil und der Schutzschicht.

Aufgabe der Erfindung ist es, das "Einbrechen" in den Metallteil von Wolframkarbid-Schutzschichten auf Metallteilen aus Kupfer, Aluminium oder deren Legierungen zu verhindern und die Haftfestigkeit dieser Schicht auf den genannten Metallteilen zu verbessern. Die Lösung dieser Aufgabe erfolgt erfindungsgemäss mit Hilfe der in Anspruch 1 genannten Merkmale.

Während bei relativ dünnen Zwischenschichten die grossen Differenzen in den Härten und in den thermischen Ausdehnungen zwischen den Metallteilen und dem Wolframkarbid nur wenig gemildert werden, ergibt sich bei den Zwischenschichten nach der vorliegenden Erfindung ein stufenweiser Uebergang von den Werten des einen Materials, d.h. des Wolframkarbids, zu den Werten des anderen Materials, also des Metallteils, wobei bei den relativ dicken Zwischenschichten nach der vorliegenden Anmeldung die zwischen den extremen Werten der genannten Materialien liegenden Eigenschaften des oder der Metalle bzw. Legierungen zur Wirkung kommen, die für die Zwischenschicht verwendet worden sind. Dabei sind z.B. die in der Grenzfläche zwischen zwei Materialien — also beispielsweise zwischen dem Wolframkarbid und dem Zwischenschichtmaterial bzw. zwischen diesem und dem Metallteilmaterial — auftretenden Eigenspannungen, die Einfluss auf die Adhäsionsfestigkeit haben, abhängig von den Unterschieden in den thermischen Ausdehnungskoeffizienten und von den Schichtdicken.

Mit den erfindungsgemässen Zwischenschichten wird daher bei gleichzeitiger Verminderung der Gefahr des "Einbrechens" der harten Schutzschicht vor allem die Haftfestigkeit der Wolfram-Karbid-Schutzschicht auf dem "weichen" Metallteil verbessert. Da sowohl die Härte als auch der thermische Ausdehnungskoeffizient für das Erreichen der angestrebten Eigenschaften — gute "Abstützung" und verbesserte Haftung der harten Wolframkarbidschicht — massgebend sind, muss bei der Auswahl eines optimalen Zwischenschichtmaterials immer die kombinierte Wirkung beider Einflussgrössen berücksichtigt werden. Eine Zwischenschicht kann gegebenenfalls — d.h. in Abhängigkeit von dem Material des Metallteils, seiner Härte und seinem thermischen Ausdehnungskoeffizienten — aus zwei oder mehr Teilschichten aufgebaut sein, wobei die Werte für die Härte und die Ausdehnung einer dem Metallteil näheren Teilschicht den entsprechenden Werten des Metallteils näher sind als diejenigen einer weiter aussen liegenden Teilschicht; als Materialien für Zwischenschichten auf einem relativ weichen Metallteil aus den genannten Bunt- oder Leicht- metallen haben sich daher vorzugsweise als geeignet erwiesen: Nickel bzw. Kobalt, Nickel- bzw. Kobaltphosphor, Nickel- bzw. Kobaltbor, Kupfer, Eisen, Nickelzinn, Nickeleisen, Kupferzinn. Bei einem Aufbau der Zwischenschicht aus zwei Teilschichten kann die innere Teilschicht vorteilhafterweise aus einem der galvanisch abegeschiedenen Stoffe Kupfer, Nickel, Kobalt, Eisen, Nickelzinn, Nickeleisen oder Kupferzinn, während eine äussere Teilschicht aus Nickel bzw. Kobalt, Nickel- bzw. Kobaltphosphor oder Nickel- bzw. Kobaltbor aufgebaut sein kann. Die Auswahl des oder der Zwischenschichtmaterialien für ein bestimmtes Grundmaterial und die Bestimmung der optimalen Schichtdicke — bzw. Schichtdicken bei mehreren Teilschichten — erfolgen unter Einhaltung der genannten Mindestdicke am besten auf Grund von Versuchsergebnissen.

Während für die Herstellung der Wolframkarbid-Schutzschicht vor allem die chemische Abscheidung aus der Gasphase bei relativ niedrigen Temperaturen angewendet wird, werden die Zwischenschichten aus geeigneten Elektrolyten nach bekannten Verfahren stromlos chemisch oder auf elektrochemischem Weg auf dem Metallteil niedergeschlagen. Das Vorhandensein der gewünschten Schichtdicke wird dabei mit Hilfe der im allgemeinen bekannten Abscheidegeschwindigkeit und der Reaktionsdauer der stromlos chemischen oder galvanischen Abscheidung gewährleistet und überwacht.

Im folgenden wird die Erfindung anhand von zwei Beispielen näher erläutert.

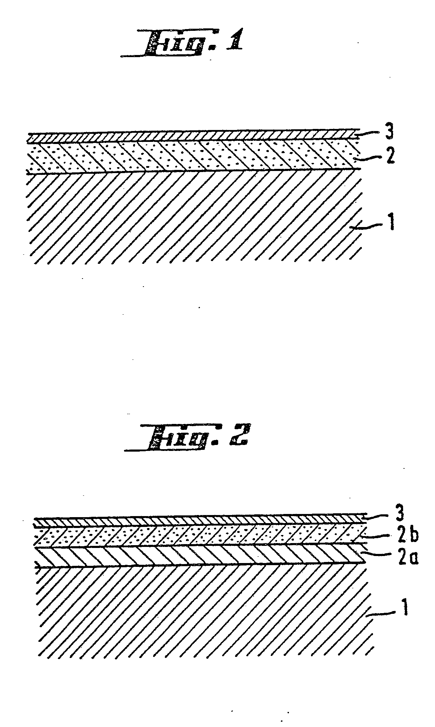

## Beispiel 1 (Fig. 1)

Es besteht die Aufgabe, einen Metallteil 1 aus Neusilber 18 einer Cu-Basislegierung mit der Zusammensetzung (in. Gew. %) Cu 61; Ni 18; Mn 0,5 und Zn Rest, mit einer einige Miktrometer — z.B. 5—6 $\mu$m — dicken Schutzschicht 3 aus Wolframkarbid zu beschichten, deren Zusammensetzung in bekannter Weise aus den nebeneinander vorliegenden Phasen $W_2C$ und $W_3C$ besteht.

Als einheitliche Zwischenschicht 2 dient eine stromlos chemisch abgeschiedene Nickelphosphor(NiP)-Schicht, deren Phosphoranteil — je nach Abscheideverfahren — 6 bis 12 % beträgt.

Als Abscheidungsverfahren für die Wolframkarbid-Schicht wird die bekannte chemische Gasphasenabscheidung angewendet (CVD-Verfahren). Als Ausgangssubstanz für das CVD-Verfahren dienen Wolfram-Hexafluorid ($WF_6$) und Benzol ($C_6H_6$).

Vor seiner Beschichtung mit Wolframkarbid wird der zu beschichtende Metallteil zunächst gereinigt und entfettet und in einen Elektrolyten, der u.a. Nickel und Phosphor — beispeilsweise in den Komponenten Nickelsulfat und Natriumhypophosphit — enthält, gebracht, in dem eine stromlose Abscheidung des als Schutzschicht 2 verwendeten Nickelphosphors stattfindet.

Die stromlose chemische Abscheidung des Nickel-Phosphors wird so lange fortgesetzt, bis die Nickel-Phosphor-Zwischenschicht eine Schichtdicke von 25 $\mu$m erreicht hat.

Der auf die geschilderte Weise mit der Schutzschicht versehene Metallteil 1 wird nunmehr in eine CVD-Anlage bekannter Bauart gebracht und auf etwa 400°C aufgeheizt, wobei die Aufheizung mit Argon bei Atmosphärendruck mit einem Argonstrom von 0,5 l/min erfolgt.

Das bei Umgebungstemperatur bereits gasförmige $WF_6$ sowie das in einem Trägergasstrom aus Argon transportierte, bei einer Temperatur zwischen 20° und 30°C verdampfte Benzol werden anschliessend in Mengenströmen von etwa 40 ml/min bzw. etwa 250 ml/min in die Anlage eingespeist, mit einem Wasserstoffstrom von etwa 500 ml/min als Trägergas vermischt, in den Reaktionsraum der Anlage geführt und an die Oberfläche des Metallteils gefördert, auf der sie sich zersetzen; auf dem Metallteil 1 bzw. der Zwischenschicht 2 wird dabei Wolframkarbid, bestehend aus den Phasen $W_2C$ und $W_3C$, abgeschieden. Die Restkomponenten werden gasförmig aus dem Reaktionsraum weggeführt.

Der Abscheidungsprozess wird etwa 90 min. fortgesetzt, wobei im Reaktionsraum etwa Atmosphärendruck gehalten wird. Bei den geschilderten Bedingungen ergibt die etwa 90 minütige Behandlung eine Wolframkarbid-Schutzschicht von etwa 6 $\mu$m.

Nach Abschluss des Abscheidungsprozesses lässt man den Metallteil 1 im Reaktionsraum langsam auf Raumtemperatur abkühlen.

## Beispiel 2 (Fig. 2)

Ein Metallteil 1 aus AlMgSi einer Aluminium-Basislegierung — mit einer Zusammensetzung (in Gew. %) Mg 0,8; Si 1; Al Rest — soll ebenfalls mit einer etwa 6 $\mu$m Dicke Wolframkarbid-Schutzschicht 3 versehen werden.

Wegen der geringen Härte der Al-Basislegierung wird hier die Schutzschicht aus zwei Teilschichten 2a, 2b aufgebaut. Die innere Teilschicht 2a besteht aus Kupfer, während die äussere, dem Wolframkarbid näher gelegene Teilschicht 2b wiederum durch eine- in diesem Beispiel 15 $\mu$m Dicke — Nickelphosphor-Schicht gebildet wird. Nach seiner Reinigung und Entfettung wird der Metallteil 1 als Kathode in einen Kupferelektrolyten — eine Mischung von $CuSO_4$, $CuCl_2$, $H_2BO_3$ und Netzmittel — getaucht. Auf Grund des durch das Bad fliessenden Stromes, dessen Stromdichte gewöhnlich im Bereich zwischen 0,4 und 4,0 A/dm² liegt, wird Kupfer galvanisch auf den Metallteil 1 so lange abgeschieden, bis eine Reinkupferschicht von etwa 15 $\mu$m darauf niedergeschlagen ist. Die Reinheit dieser Kupferschicht beträgt etwa 99 %, während als Verunreinigung vor allem Schwefel vorhanden ist.

Die benutzte Stromdichte beträgt 1,0 A/dm²; bei dieser Stromdichte ist die Abscheiderate etwa 0,2 µm/min.

Anschliessend erfolgt, wie bereits geschildert, unter Umständen nach erneuter vorheriger Reinigung der kupferbeschichteten Oberfläche die stromlos chemische Abscheidung des Nickel-Phosphors, ehe in gleicher Weise wie bei Beispiel 1 die Wolframkarbid-Schutzschicht 3 hergestellt wird. Die Dicke der Nickel-Phosphor-Teilschicht 2b beträgt ebenfalls etwa 15 µm.

Gegenüber dem Beispiel 1 ist für die Abscheidung nach dem CVD-Verfahren lediglich die Temperatur des Metallteils 1 im Reaktionsraum der CVD-Anlage auf 350°C erniedrigt und die Reaktionsdauer auf 2 Stunden erhöht.

In der nachstehenden Tabelle sind für beide Beispiele die Werte der thermischen Ausdehnungskoeffizienten $\alpha$ und Härtewerte für die einzelnen Komponenten der erfindungsgemässen Beziehungen aufgetragen:

| | $W_2C/W_3C$ | NiP | Cu | NS 18 | AlMgSi |
|---|---|---|---|---|---|
| $\alpha.10^6$ (°C⁻¹) | 5—6 | 13 | | 17 | |
| Härte (HV) | 2200 | 1000 | | 140 | |
| $\alpha.10^6$ (°C⁻¹) | 5—6 | 13 | 17 | | 23 |
| Härte (HV) | 2200 | 1000 | 120 | | 50 |

Neuerdings haben sich auch galvanisch abgeschiedene Dispersionsschichten für Zwischenschichten gemäss der vorliegenden Erfindung als geeignet erwiesen. Bei diesen galvanischen Dispersionsschichten werden unslösliche, nicht metallische Partikel — z.B. aus keramischen Stuffen — aus einem Bad während der kathodischen Abscheidung eines Matrixmetalles — Nickel, Kupfer, Kobalt, Eisen oder Legierungen eines dieser Metalle, z.B. Messing — in das Matrixmetall der Zwischenschicht dispers eingebaut.

## Patentansprüche

1. Mit einer verschleiss- und korrosionsfesten Wolframkarbid-Schutzschicht versehener Metallteil, der aus Aluminium oder Kupfer oder ihren Legierungen besteht und eine relativ geringe Härte sowie einen relativ grossen thermischen Ausdehnungskoeffizienten $\alpha$ hat, wobei zwischen dem Metallteil und der Schutzschicht mindestens eine Zwischenschicht vorgesehen ist, dadurch gekennzeichnet, dass die Zwischenschicht (2; 2a, 2b) eine Dicke von mindestens 20 µm hat, und dass ferner ihre Härte höher als diejenige des Metallteils (1), jedoch niedriger als diejenige des Wolframkarbids (3) und ihre thermische Ausdehnung kleiner als diejenige des Metallteils (1), jedoch grösser als diejenige des Wolframkarbids (3), sind.

2. Metallteil nach Anspruch 1, dadurch gekennzeichnet, dass die Zwischenschicht (2; 2a, 2b) aus Nickel (Ni) bzw. Kobalt (Co), Nickel- bzw. Kobaltphosphor (NiP bzw. CoP), Nickel- bzw. Kobaltbor (NiB bzw. CoB), Kupfer (Cu), Eisen (Fe), Nickelzinn (NiSn), Nickeleisen (NiFe) oder Kupferzinn (CuSn) besteht.

3. Metallteil nach Anspruch 1, dadurch gekennzeichnet, dass die Zwischenschicht aus mindestens zwei Teilschichten (2a, 2b) aufgebaut ist, wobei die Werte für die Härte und die Ausdehnung einer dem Metallteil (1) näheren inneren Teilschicht (2a) den entsprechenden Werten des Metallteils (1) näher sind als diejenigen einer äusseren Teilschicht (2b).

4. Metallteil nach Anspruch 2 und 3, dadurch gekennzeichnet, dass eine innere Teilschicht (2a) aus einem der galvanisch abgeschiedenen Stoffe Kupfer, Nickel, Kobalt, Eisen, Nickelzinn, Nickeleisen oder Kupferzinn besteht, während eine äussere Teilschicht (2b) aus Nickel bzw. Kobalt, Nickel- bzw. Kobaltphosphor oder Nickel- bzw. Kobaltbor besteht.

## Claims

1. A metal part which is provided with a wear and corrosion resistant tungsten carbide protective layer and which consists of aluminium or copper or their alloys, and which has a relatively low hardness and a relatively high coefficient of thermal expansion $\alpha$, at least one intermediate layer being provided between the metal part and the protective layer, characterised in that the intermediate layer (2; 2a, 2b) has a thickness of at least 20 µm, and also its hardness is greater than that of the metal part (1) but lower than that of the tungsten carbide (3) and its thermal expansion is lower than that of the metal part (1) but greater than that of tungsten carbide (3).

2. A metal part according to claim 1, characterised in that the intermediate layer (2; 2a, 2b) consists of nickel (Ni) or cobalt (Co), nickel or cobalt phosphorus (NiP or CoP), nickel or cobalt boron (NiB or CoB), copper (Cu), iron (Fe), nickel tin (NiSn), nickel iron (NiFe) or copper tin (CuSn).

3. A metal part according to claim 1, characterised in that the intermediate layer is built up from

# 0 018 432

at least two partial layers (2a, 2b), the values for the hardness and expansion of one partial layer (2a), the inner one closer to the metal part (1), being closer to the corresponding values of the metal part (1) than those of an outer partial layer (2b).

4. A metal part according to claim 2 and 3, characterised in that an inner partial layer (2a) consists of one of the galvanically deposited substances copper, nickel, cobalt, iron, nickel tin, nickel iron or copper tin, while an outer partial layer (2b) consists of nickel or cobalt, nickel or cobalt phosphorus or nickel or cobalt boron.

## Revendications

1. Pièce mètallique en aluminium, cuivre ou alliages de ces mètaux, présèntant une dureté relativement faible et un coefficient de dilatation thermique $\alpha$ relativement élevé, munie d'une couche protectrice de carbure de tungstène résistant à l'usure et la corrosion, avec une couche intermédiaire au moins entre la pièce métallique et la couche protectrice, ladite pièce métallique étant caractérisée en ce que la couche intermédiaire (2; 2a, 2b) présente une épaisseur minimale de 20 $\mu$m, et sa dureté est supérieure à celle de la pièce métallique (1), mais inférieure à celle du carbure de tungstène (3), et sa dilatation thermique est inférieure à celle de la pièce métallique (1), mais supérieure à celle du carbure de tungstène (3).

2. Pièce métallique selon revendication 1, caractérisée en ce que la couche intermédiaire (2; 2a, 2b) est en nickel (Ni) ou cobalt (Co), nickel-phosphore ou cobalt-phosphore (NiP ou CoP), nickel-bore ou cobalt-bore (NiB ou CoB), cuivre (Cu), fer (Fe), nickel-étain (NiSn), nickel-fer (NiFe) ou cuivre-étain (CuSn).

3. Pièce métallique selon revendication 1, caractérisée en ce·que la couche intermédiaire est constituée par deux couches partielles (2a, 2b) au moins, les valeurs de la dureté et de la dilatation de la couche partielle intérieure (2a) voisine de la pièce métallique (1) sont plus proches des valeurs correspondantes de la pièce métallique (1) que de celle de la couche partielle extérieure (2b).

4. Pièce métallique selon revendications 2 et 3, caractérisée en ce qu'une couche partielle intérieure (2a) est en cuivre, nickel, cobalt, fer, nickel-étain, nickel-fer ou cuivre-étain déposé galvaniquement, tandis qu'une couche partielle extérieure (2b) est en nickel ou cobalt, nickel-phosphore ou cobalt-phosphore, ou nickel-bore ou cobalt-bore.

0018432

Fig. 1

Fig. 2

1